# EUROPÄISCHE PATENTSCHRIFT

(11) **EP 2 601 439 B1**
(45) Veröffentlichungstag und Bekanntmachung des Hinweises auf die Patenterteilung: **10.05.2017**
(21) Anmeldenummer: 11728256.6
(22) Anmeldetag: 24.06.2011
(51) Int. Cl.: F21V 19/00, F21S 8/12, F21V 29/00

(54) **OPTOELEKTRONISCHES LEUCHTMODUL UND KFZ-SCHEINWERFER**
OPTOELECTRICAL LIGHT MODULE AND CORRESPONDING VEHICLE LIGHT
MODULE D'ÉCLAIRAGE OPTOÉLECTRONIQUE ET PHARE DE VÉHICULE

(30) Priorität: 02.08.2010 DE 102010033093
(43) Veröffentlichungstag der Anmeldung: 12.06.2013
(73) Patentinhaber: OSRAM Opto Semiconductors GmbH, 93055 Regensburg (DE)
(72) Erfinder: SINGER, Frank, 93128 Regenstauf (DE); HAUG, Thomas, 85051 Ingolstadt (DE); SAUERER, Alexander, 80333 München (DE)
(74) Vertreter: Epping - Hermann - Fischer
(86) Internationale Anmeldenummer: PCT/EP2011/060646
(87) Internationale Veröffentlichungsnummer: WO 2012/016759

(56) Entgegenhaltungen:
- EP-A1- 1 936 263
- DE-A1-102007 049 310
- US-A1- 2006 141 851
- US-A1- 2010 067 251

## Beschreibung

Es wird ein optoelektronisches Leuchtmodul angegeben. Darüber hinaus wird ein Kfz-Scheinwerfer mit einem solchen Leuchtmodul angegeben.

In der Druckschrift US 2008/0008427 A1 ist ein lichtemittierendes Modul und ein Beleuchtungsbauteil für ein Fahrzeug angegeben.

Die Druckschrift US 2010/0067251 A1 betrifft eine Leuchte für ein Kraftfahrzeug.

Ein Sockel für ein LED-Beleuchtungssystem sowie ein solches LED-Beleuchtungssystem finden sich in der gattungsgemäßen Druckschrift US 2006/0141851 A1.

Es ist in der Druckschrift EP 1 936 263 A1 eine Befestigungsvorrichtung für Leuchtdioden beschrieben.

Eine zu lösende Aufgabe besteht darin, ein Leuchtmodul anzugeben, das effizient entwärmbar ist.

Diese Aufgabe wird gelöst durch ein Leuchtmodul mit den Merkmalen des Patentanspruchs 1. Die Leiterplatte ist von einer Öffnung vollständig durchdrungen. Mit anderen Worten reicht die Öffnung von einer Leiterplattenoberseite bis zu einer dieser gegenüberliegenden Leiterplattenunterseite. Öffnung bedeutet insbesondere, dass in der Leiterplatte ein Durchbruch geschaffen ist, der an mindestens drei Seiten, bevorzugt an mindestens vier Seiten oder ringsum, von einem Material der Leiterplatte umgeben ist. Die Leiterplatte umfasst mindestens eine Befestigungseinrichtung. Die Befestigungseinrichtung ist dazu eingerichtet, das Leuchtmodul an einem externen Kühlkörper, der nicht zu dem Leuchtmodul gehört, zu befestigen. Die Befestigungseinrichtung beinhaltet beispielsweise Ausnehmungen zur Aufnahme von Schrauben. Das Leuchtmodul umfasst einen Träger. Der Träger besteht aus oder weist bevorzugt ein Material mit einer hohen thermischen Leitfähigkeit auf. Zum Beispiel beträgt eine mittlere, spezifische thermische Leitfähigkeit des Trägers mindestens 50 W/(m K) oder mindestens 80 W/(m K) oder mindestens 120 W/(m K). Der Träger ist in der Öffnung der Leiterplatte angebracht. Es kann sich ein überwiegender Teil des Trägers, beispielsweise mindestens 50 % oder mindestens 80 %, in der Öffnung befinden, also in Projektion auf eine Ebene senkrecht zu der Leiterplattenoberseite insbesondere zwischen der Leiterplattenunterseite und der Leiterplattenoberseite. Das Leuchtmodul weist mindestens einen optoelektronischen Halbleiterchip auf, der an einer Trägeroberseite des Trägers angebracht ist. Bei dem Halbleiterchip handelt es sich bevorzugt um eine Leuchtdiode. Die Leuchtdiode ist insbesondere zur Erzeugung blauen Lichts, weißen Lichts oder nahinfraroter Strahlung eingerichtet. Eine Halbleiterschichtenfolge des optoelektronischen Halbleiterchip kann auf einem III-V-Verbindungshalbleitermaterial basieren, beispielsweise auf GaN, InGaN, AlGaN oder InAlGaN. Der Halbleiterchip ist über den Träger elektrisch mit der Leiterplatte verbunden. Mit anderen Worten ist der Halbleiterchip nicht unmittelbar elektrisch mit der Leiterplatte kontaktiert, sondern nur mittelbar über den Träger. Beispielsweise befinden sich auf dem Träger Leiterbahnen zur Kontaktierung des Halbleiterchips, die über ein Verbindungsmittel mit Leiterbahnen auf der Leiterplatte kontaktiert sind. Die Leiterplatte ist mit dem Träger mechanisch fest verbunden. Das bedeutet, dass im bestimmungsgemäßen Gebrauch des Leuchtmoduls sich die Leiterplatte nicht von dem Träger separiert oder umgekehrt. Erfindungsgemäß ist das Leuchtmodul als eine einzige, zusammenhängende Einheit handhabbar. Bevorzugt sind die Leiterplatte und der Träger derart fest miteinander verbunden, dass bei einer Montage zum Beispiel auf einem externen Kühlkörper kein signifikantes relatives Verschieben der Leiterplatte bezüglich dem Träger in einer lateralen Richtung stattfindet. Eine solche Verschiebung beträgt bevorzugt höchstens 250 µm oder höchstens 100 µm. Die Leiterplatte ist dazu eingerichtet, eine mechanische Kraft auf den Träger auszuüben und den Träger an den externen Kühlkörper anzudrücken. Der Träger ist dann in montiertem Zustand über die Leiterplatte an den Kühlkörper angedrückt. Dadurch ist die Leiterplatte über die Befestigungseinrichtung unmittelbar an dem Kühlkörper fest montierbar und der Träger nur mittelbar über die Leiterplatte. Das Leuchtmodul ist frei von einem Verbindungsmittel oder von einer Befestigungseinrichtung, die dazu eingerichtet ist, den Träger unmittelbar mechanisch fest mit dem externen Kühlkörper zu verbinden. Der Träger ist dazu eingerichtet, mit einer Trägerunterseite, die der Trägeroberseite mit dem Halbleiterchip gegenüberliegt, plan an dem externen Kühlkörper aufzuliegen. Die Trägerunterseite ist also eben gestaltet. Eine Verzahnung oder ein Ineinandergreifen von Teilen der Trägerunterseite mit Teilen des Kühlkörpers ist nicht vorgesehen. Speziell ist der Träger dazu eingerichtet, auf einer eben geformten Oberseite des Kühlkörpers angebracht zu werden. Hierdurch ist eine große Auflagefläche und eine gute thermische Ankopplung des Trägers an dem externen Kühlkörper gewährleistbar. Das optoelektronische Leuchtmodul umfasst eine Leiterplatte, die von einer Öffnung vollständig durchdrungen ist. Die Leiterplatte weist mindestens eine, bevorzugt mindestens zwei oder genau zwei Befestigungseinrichtungen für eine mechanische Befestigung des Leuchtmoduls an einem externen Kühlkörper auf. Ein Träger des Leuchtmoduls ist in der Öffnung angebracht. Mindestens ein optoelektronischer Halbleiterchip befindet sich an einer Trägeroberseite des Trägers und ist über den Träger elektrisch mit der Leiterplatte verbunden. Die Leiterplatte ist außerdem mit dem Träger mechanisch fest verbunden. Weiter ist die Leiterplatte dazu eingerichtet, eine mechanische Kraft auf den Träger auszuüben und den Träger an den externen Kühlkörper anzudrücken. Der Träger ist dazu eingerichtet, mit einer Trägerunterseite plan an dem externen Kühlkörper aufzuliegen.

Bei dem beschriebenen Leuchtmodul ist der Träger plan und verbindungsmittelfrei an einem externen Kühlkörper angebracht zu sein. Alternativ hierzu ist es möglich, einen Träger über ein Verbindungsmittel, das sich zwischen dem Träger und dem Kühlkörper befindet, an dem Kühlkörper zu befestigen.

Geeignete Materialien für den Träger mit einer hohen thermischen Leitfähigkeit und einer thermischen Ausdehnung ähnlich der des Halbleiterchips sind beispielsweise Keramiken. Keramiken weisen typisch einen thermischen Ausdehnungskoeffizienten von circa 5 x 10⁻⁶ K⁻¹ auf. Metalle für einen Kühlkörper wie Aluminium oder Kupfer weisen dahingegen einen vergleichsweise großen thermischen Ausdehnungskoeffizienten im Bereich von etwa 15 x 10⁶ K⁻¹ bis circa 25 x 10⁶ K⁻¹ auf. Ein Verbindungsmittel muss daher in der Lage sein, die Unterschiede im thermischen Ausdehnungskoeffizienten auszugleichen, da ansonsten sich nach vielmaligem Einschalten und Ausschalten des Leuchtmoduls der Träger von dem Kühlkörper lösen kann.

Starre metallische Lote oder zum Beispiel mit Silber versetzte Epoxide als Verbindungsmittel sind im Regelfall nicht in der Lage, die Spannungen aufgrund der unterschiedlichen thermischen Ausdehnungskoeffizienten zwischen dem Träger und dem Kühlkörper zu kompensieren. Hierzu sind vergleichsweise weiche, insbesondere auf einem Silikon basierende Kleber vonnöten, die zum Beispiel mit Bariumnitrid gefüllt sind. Solche Kleber weisen jedoch eine vergleichsweise geringe thermische Leitfähigkeit in der Größenordnung von 2 W/(m K) auf und sind zudem in vergleichsweise großen Schichtdicken zwischen 20 µm und 60 µm aufzutragen. Durch den hohen thermischen Widerstand der Verbindungsmittelschicht ist die Entwärmbarkeit des Leuchtmoduls somit signifikant reduziert. Dadurch, dass bei dem hier beschriebenen Leuchtmodul über die Leiterplatte der Träger unmittelbar und verbindungsmittelfrei auf dem Kühlkörper anpressbar ist, ist ein thermischer Widerstand zwischen dem Kühlkörper und dem Träger reduzierbar und eine Entwärmbarkeit erhöhbar. Die Trägerunterseite und die Leiterplattenunterseite jeweils planar geformt und parallel zueinander orientiert, im Rahmen der Herstellungstoleranzen. Erfindungsgemäß ragt die Trägerunterseite aus der Öffnung, in der der Träger angebracht ist, heraus. Die Überragung beträgt höchstens 100 µm. Beispielsweise liegt die Überragung zwischen einschließlich 10 µm und 100 µm, insbesondere zwischen einschließlich 10 µm und 50 µm. Die Trägerunterseite überragt die Leiterplattenunterseite nur, solange das Leuchtmodul nicht an dem externen Kühlkörper montiert ist. Ist das Leuchtmodul auf dem Kühlkörper montiert, so verlaufen die Leiterplattenunterseite und die Trägerunterseite bevorzugt in einer gemeinsamen Ebene, in der auch eine Kühlkörperoberseite liegen kann. Gemäß zumindest einer Ausführungsform des optoelektronischen Leuchtmoduls beinhaltet diese eine Leiterplatte. Bei der Leiterplatte handelt es sich zum Beispiel um eine Metallkernplatine oder um eine Platine mit einem insbesondere auf einem Epoxid basierendem Kern, auf dem eine metallische Schicht aufgebracht ist, wobei die metallische Schicht zu Leiterbahnen strukturiert und von einer weiteren dielektrischen Schicht zumindest stellenweise bedeckt sein kann. Ebenso ist es möglich, dass es sich bei der Leiterplatte um einen spritzgegossenen Schaltungsträger, englisch Molded Interconnect Device oder kurz MID, handelt.

Gemäß zumindest einer Ausführungsform des optoelektronischen Leuchtmoduls ist die Leiterplatte dazu eingerichtet, den Träger mit einer mechanischen Kraft zwischen einschließlich 5 N und 100 N, insbesondere zwischen einschließlich 15 N und 80 N oder zwischen einschließlich 40 N und 80 N an den externen Kühlkörper anzudrücken. Alternativ oder zusätzlich ist die Leiterplatte dazu eingerichtet, die Trägerunterseite mit einem mittleren Druck zwischen einschließlich 0,2 MPa und 20 MPa, bevorzugt zwischen einschließlich 0,25 MPa und 5 MPa, an die Kühlkörperoberseite anzudrücken.

Gemäß zumindest einer Ausführungsform des Leuchtmoduls weist dieses zumindest zwei Befestigungszungen auf. Die Befestigungszungen verlaufen in Verlängerung der Leiterplattenoberseite und überdecken die Öffnung in der Leiterplatte, in Draufsicht gesehen, teilweise. Die Befestigungszungen sind bevorzugt mit der Trägeroberseite mechanisch und/oder elektrisch fest verbunden. Die Verbindung zwischen den Befestigungszungen und dem Träger ist derart ausgestaltet, dass sie sich im bestimmungsgemäßen Gebrauch des Leuchtmoduls nicht löst.

Gemäß zumindest einer Ausführungsform des Leuchtmoduls sind die Befestigungszungen dazu eingerichtet, den Träger an den externen Kühlkörper anzudrücken. Mit anderen Worten üben die Befestigungszungen eine Kraft in eine Richtung senkrecht zu der Trägerunterseite auf den Träger aus.

Gemäß zumindest einer Ausführungsform des Leuchtmoduls sind die Befestigungszungen einstückig mit der Leiterplatte ausgebildet. Insbesondere sind beim Erzeugen der Öffnung in der Leiterplatte bestimmte Materialbereiche, die die Befestigungszungen ausbilden und die in die Öffnung hineinragen, nicht weggenommen. Es sind die Befestigungszungen dann nicht separat gefertigt und nicht nachträglich an die Leiterplatte angebracht, sondern die Befestigungszungen sind integraler Bestandteil der Leiterplatte. Die Befestigungszungen können also gleichzeitig mit der Öffnung gefertigt sein.

Gemäß zumindest einer Ausführungsform des Leuchtmoduls weisen die Befestigungszungen ein mechanisch elastisch verformbares Material auf oder bestehen hieraus. Insbesondere ist das Material der Befestigungszungen über einen gesamten Temperaturbereich hinweg, in dem das Leuchtmodul bestimmungsgemäß eingesetzt wird, elastisch verformbar.

Gemäß zumindest einer Ausführungsform des Leuchtmoduls weisen die Befestigungszungen eine Federkonstante, in eine Richtung senkrecht zu der Trägeroberseite und/oder zu der Trägerunterseite auf, die zwischen einschließlich 50 kN/m und 5 MN/m oder zwischen einschließlich 250 kN/m und 3 MN/m liegt. Mit anderen Worten ermöglichen die Befestigungszungen bei einem vergleichsweise kleinen Federweg eine hohe Kraft auf dem Träger auszuüben.

Gemäß zumindest einer Ausführungsform des Leuchtmoduls ist mindestens eine der Befestigungszungen oder sind alle Befestigungszungen von dem Halbleiterchip elektrisch isoliert. Eine elektrische Kontaktierung ist von einer mechanischen Kontaktierung des Trägers dann bevorzugt getrennt.

Gemäß zumindest einer Ausführungsform des Leuchtmoduls liegt ein mittlerer Abstand in einer lateralen Richtung zwischen der Leiterplatte und dem Träger zwischen einschließlich 150 µm und 750 µm. Die Leiterplatte sowie der Träger befinden sich in lateraler Richtung also vergleichsweise nahe aneinander.

Gemäß zumindest einer Ausführungsform des Leuchtmoduls umgibt die Leiterplatte den Träger in lateraler Richtung formschlüssig. Bevorzugt umgibt die Leiterplatte den Träger ringsum in lateraler Richtung vollständig und formschlüssig.

Gemäß zumindest einer Ausführungsform des Leuchtmoduls unterscheiden sich die thermischen Ausdehnungskoeffizienten des Materials der Leiterplatte und des Materials des Trägers um höchstens einen Faktor 4, bevorzugt um höchstens einen Faktor 3 voneinander. Durch die ähnlichen Ausdehnungskoeffizienten ist eine thermische Belastung des Leuchtmoduls reduzierbar.

Gemäß zumindest einer Ausführungsform des Leuchtmoduls ist das Material des Trägers bei einer Temperatur von 400 K spröder als ein die Leiterplatte mechanisch tragendes Material. Beispielsweise weist der Träger ein keramisches Material auf oder besteht aus einem solchen. Keramiken sind vergleichsweise spröde Materialien, die nur mit relativ hohem Aufwand mechanisch bearbeitbar sind. Das tragende, weniger spröde Material der Leiterplatte, bevorzugt ein Metall oder eine Metalllegierung, ist leichter bearbeitbar. Insbesondere sind die Befestigungseinrichtung in die Leiterplatte mit geringerem Aufwand formbar als in dem Träger.

Gemäß zumindest einer Ausführungsform des Leuchtmoduls weist die Trägerunterseite eine mittlere Rauheit von höchstens 10 µm, insbesondere von höchstens 5 µm oder von höchstens 2 µm auf. Mit anderen Worten ist die Trägerunterseite vergleichsweise glatt. Die mittlere Rauheit wird auch als Rₐ bezeichnet.

Es wird darüber hinaus ein Kfz-Scheinwerfer angegeben. Der Kfz-Scheinwerfer beinhaltet mindestens ein optoelektronisches Leuchtmodul, wie in Verbindung mit einer oder mehrerer der oben genannten Ausführungsformen beschrieben. Merkmale des Kfz-Scheinwerfers sind daher auch für das optoelektronische Leuchtmodul offenbart und umgekehrt.

In mindestens einer Ausführungsform des Kfz-Scheinwerfers beinhaltet dieser wenigstens einen Kühlkörper, wobei das Leuchtmodul auf einer Kühlkörperoberseite des Kühlkörpers befestigt ist und insbesondere die Trägerunterseite durch die Leiterplatte an die Kühlkörperoberseite angedrückt ist.

Nachfolgend wird ein hier beschriebenes optoelektronisches Leuchtmodul sowie ein hier beschriebener Kfz-Scheinwerfer unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1 bis 4: schematische Darstellungen von Ausführungsbeispielen von hier beschriebenen optoelektronischen Leuchtmodulen, und
- Figur 5: eine schematische Darstellung einer Abwandlung eines Leuchtmoduls.

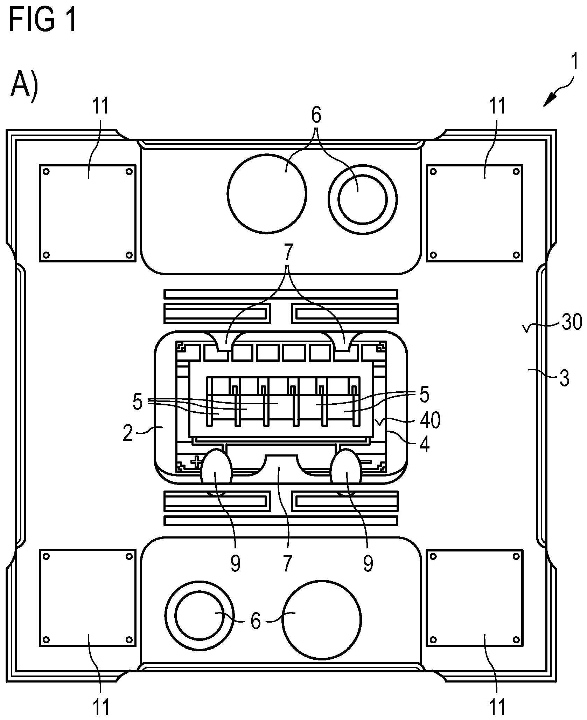

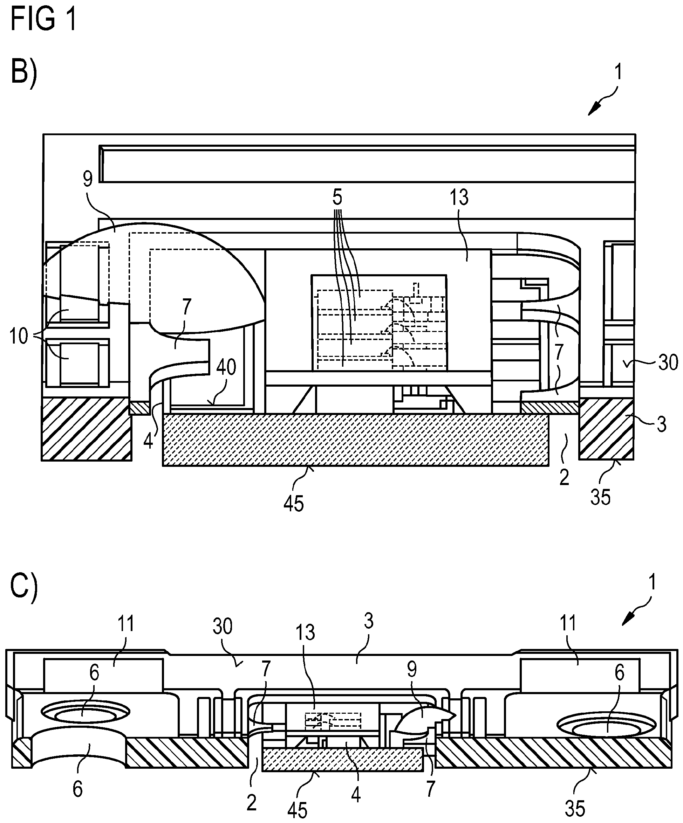

In Figur 1 ist ein Ausführungsbeispiel eines Leuchtmoduls 1 illustriert, siehe die schematische Draufsicht in Figur 1A sowie die schematischen perspektivischen Schnittdarstellungen in den Figuren 1B sowie 1C.

Eine Leiterplatte 3 weist eine Öffnung 2 auf. In der Öffnung 2 ist ein Träger 4 angebracht. Auf einer Trägeroberseite 40 des Trägers 4 befinden sich optoelektronische Halbleiterchips 5. Eine mechanische Verbindung zwischen dem Träger 4 und der Leiterplatte 3 ist durch Befestigungszungen 7 hergestellt. Eine elektrische Verbindung zwischen Leiterbahnen 10 der Leiterplatte 3 sowie dem Träger 4 ist durch elektrische Brücken 9 realisiert, die einen Bond-Draht beinhalten, der von einer Vergussmasse umgossen ist. Zur Befestigung des Leuchtmoduls 1 an einen nicht gezeichneten, externen Kühlkörper, der nicht zu dem Leuchtmodul 1 gehört, weist die Leiterplatte 3 Befestigungseinrichtungen 6 auf, die als Führung für zum Beispiel Schrauben, mittels derer das Leuchtmodul 1 an den Kühlkörper anschraubbar ist, dienen können. Zu einer elektrischen Kontaktierung des Leuchtmoduls 1 sind in Eckbereichen der Leiterplatte 3 jeweils Lötpads 11 angeordnet, die mit den Leiterbahnen 10 elektrisch verbunden sind.

Die Leiterplatte 3 gemäß Figur 1 ist eine bedruckte Metallkernplatine. Die Befestigungszungen 7 bestehen aus einem Material des Metallkerns der Leiterplatte 3. Es sind die Befestigungszungen 7 also einstückig mit der Leiterplatte 3 ausgebildet. Die Befestigungszungen 7 sind mechanisch elastisch und verformen sich bei einer Montage des Leuchtmoduls 1 an dem externen Kühlkörper, wodurch eine mechanische Kraft auf dem Träger 4 ausgeübt und der Träger 4 auf den nicht gezeichneten Kühlkörper aufgedrückt wird. Um dies zu ermöglichen, überragt eine Trägerunterseite 45, die der Trägeroberseite 40 gegenüberliegt, eine Leiterplattenunterseite 35, in eine Richtung senkrecht zu der Trägeroberseite 40 sowie senkrecht zu der Trägerunterseite 45.

Die Befestigungszungen 7 sind von den Halbleiterchips 5 elektrisch isoliert. Beispielsweise sind die Befestigungszungen 7 an die Trägeroberseite 40 angelötet oder angeklebt. Alternativ hierzu ist es möglich, dass eine mechanische Verbindung zwischen dem Träger 4 sowie der Leiterplatte 3 durch ein Vergussmaterial der elektrischen Brücke 9 realisiert ist.

Der Träger 4 beinhaltet zum Beispiel eine Keramik wie Aluminiumnitrid oder Aluminiumoxid oder besteht aus einer solchen Keramik. Ebenso ist es möglich, dass der Träger 4 Siliziumnitrid oder Siliziumcarbid umfasst oder hieraus besteht oder dass der Träger 4 aus einem Halbleitermaterial wie Silizium oder Germanium gefertigt ist. Weist der Träger 4 ein elektrisch leitfähiges Material auf, so ist dieses bevorzugt mindestens stellenweise mit einer dünnen Passivierungsschicht versehen, beispielsweise aus Siliziumnitrid, die nur einen vernachlässigbaren thermischen Widerstand aufweist.

Laterale Abmessungen des Trägers 4 liegen zum Beispiel zwischen einschließlich 3 mm x 5 mm und 5 mm x 8 mm, falls das Leuchtmodul 1 mehrere Halbleiterchips 5 umfasst, oder zwischen einschließlich 1 mm x 4 mm und 3 mm x 5 mm, falls das Leuchtmodul nur einen einzigen Halbleiterchip 5 beinhaltet, anders als in Figur 1 dargestellt. Beispielsweise fällt im bestimmungsgemäßen Betrieb des Leuchtmoduls 1 pro Halbleiterchip 5 eine Abwärme von mindestens 3 W an. Um diese Abwärme effizient abzuführen, beträgt ein thermischer Widerstand des Leuchtmoduls 1, gerechnet von einer aktiven strahlungserzeugenden Schicht der Halbleiterchips 5 bis zu der Trägerunterseite 45, höchstens 2,0 K/W oder höchstens 1,5 K/W.

Die Befestigungszungen 7 reichen beispielsweise zwischen einschließlich 0,3 mm und 1,0 mm in die Öffnung 2 hinein. Eine Dicke der Befestigungszungen 7 beträgt beispielsweise zwischen einschließlich 0,2 mm und 1,0 mm. Ein Kernmaterial der Leiterplatte 3, aus dem die Befestigungszungen 7 gemäß Figur 1 geformt sind, ist zum Beispiel Aluminium oder Kupfer.

Anders als in Figur 1 dargestellt ist es ebenso möglich, dass die elektrische Brücke 9 alternativ oder zusätzlich zu einem Bond-Draht ein metallisches Band oder eine auf die Leiterplattenoberseite 30 sowie auf die Trägeroberseite 40 aufgebrachte Schichtenfolge aus dielektrischen und elektrisch leitfähigen Schichten umfasst oder hieraus besteht. Optional ist den Halbleiterchips 5 eine strahlungsdurchlässige, insbesondere eine klarsichtige Abdeckung 13 nachgeordnet. Der Abdeckung 13 ist entlang einer Abstrahlrichtung bevorzugt eine weitere Optik, in den Figuren nicht gezeichnet, nachgeordnet.

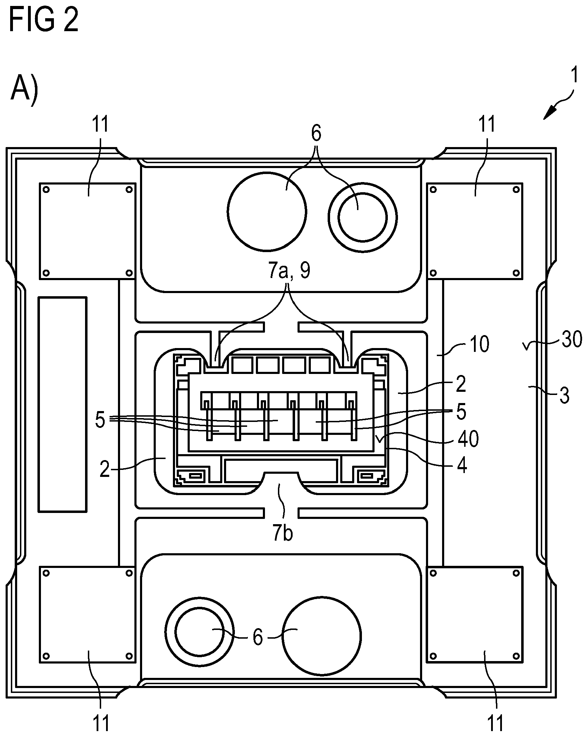

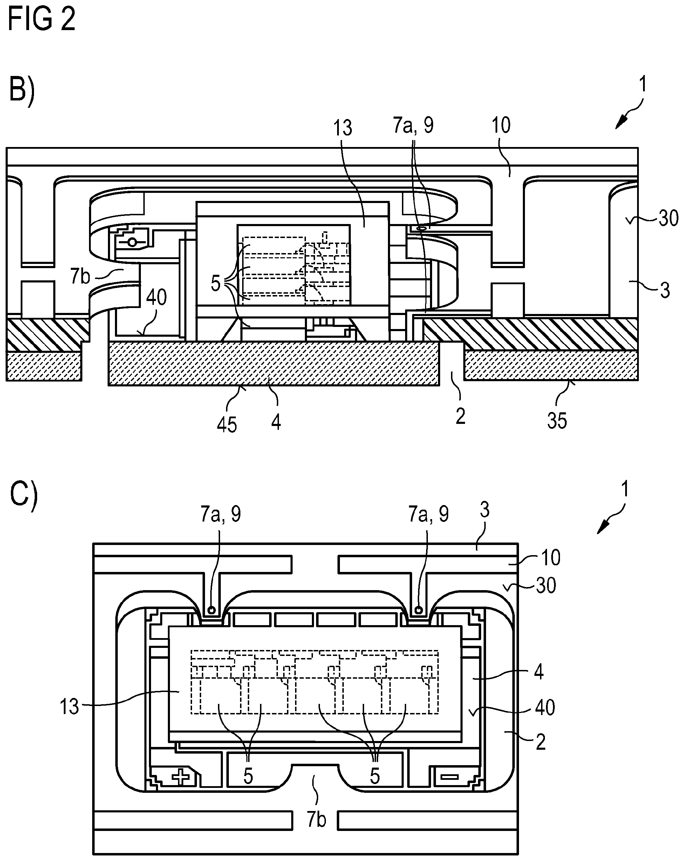

Ein weiteres Ausführungsbeispiel des Leuchtmoduls 1 ist in der schematischen Draufsicht gemäß Figur 2A, der perspektivischen Schnittdarstellung gemäß Figur 2B sowie der perspektivischen Draufsicht gemäß Figur 2C illustriert.

Bei der Leiterplatte 3 gemäß der Figur 2 handelt es sich ebenfalls um eine Metallkernplatine. Die insgesamt drei Befestigungszungen 7a, 7b sind aus einem Epoxid-basierten Material der Leiterplatte 3 geformt, insbesondere aus FR4, das den Metallkern der Leiterplatte 3 abdeckt und auf das die Leiterbahnen 10 aufgebracht oder strukturiert sind. Die Befestigungszungen 7a, 7b sind mit Leiterbahnen an der Trägeroberseite 40 verlötet. Weiterhin weisen die zwei Befestigungszungen 7a elektrische Durchkontaktierungen auf, die die Leiterplattenoberseite 40 mit der Trägeroberseite 40 verbinden. Somit erfolgt über die Befestigungszungen 7a neben der mechanischen Verbindung zusätzlich eine elektrische Kontaktierung des Trägers 4 und damit einhergehend der optoelektronischen Halbleiterchips 5.

Wie auch gemäß Figur 1 sind die Halbleiterchips 5 elektrisch in Serie geschaltet, so dass zur Kontaktierung des Trägers 4 insgesamt nur zwei elektrische Kontakte mittels der Befestigungszungen 7b vorhanden sind. Durch die insgesamt drei Befestigungszungen 7a, 7b erfolgt eine Dreipunktauflage des Trägers 4 an der Leiterplatte 3, wodurch eine besonders stabile Halterung des Trägers 4 und eine gleichmäßige Kraftverteilung auf die Befestigungszungen 7a, 7b realisierbar ist. Anders als dargestellt können, wie auch in allen anderen Ausführungsbeispielen, mehr als drei Befestigungszungen vorhanden sein. Ebenfalls können die Halbleiterchips 5 optional, wie auch in allen anderen Ausführungsbeispielen, elektrisch parallel geschaltet und/oder einzeln ansteuerbar oder zu Gruppen zusammengefasst ansteuerbar sein.

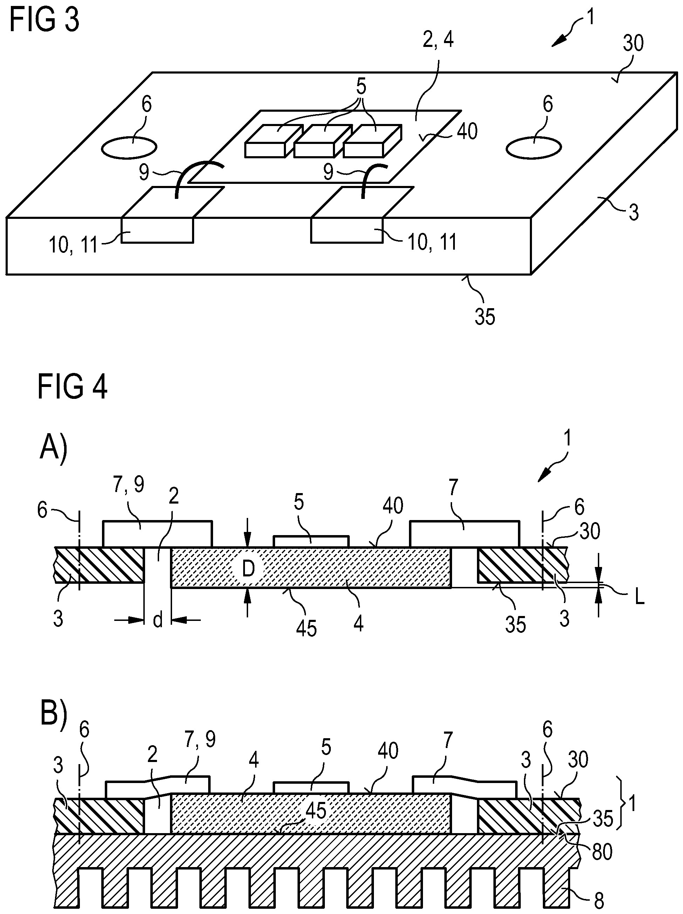

Ein weiteres Ausführungsbeispiel des Leuchtmoduls 1 ist in einer perspektivischen Darstellung in Figur 3 gezeigt. Die Leiterplatte 3 ist ein spritzgegossener Schaltungsträger, kurz MID, der den Träger 4 in lateraler Richtung ringsum vollständig und formschlüssig umgibt. Die Öffnung 2 in der Leiterplatte 3 ist vollständig durch den Träger 4 mit den Halbleiterchips 5 ausgefüllt. Auch beim Ausführungsbeispiel gemäß Figur 3 überragt der Träger 4 die Leiterplatte 3 bevorzugt an der Leiterplattenunterseite 35, in Figur 3 nicht zu sehen.

In die Leiterplatte 3 sind die Leiterbahnen 10 sowie die Lötpads 11 monolithisch integriert. Die elektrischen Brücken 9 sind durch Bond-Drähte gebildet. Alternativ hierzu können die elektrischen Brücken 9 durch durchgehende elektrisch leitende Schichten, die unmittelbar auf die Leiterplattenoberseite 30 sowie auf die Trägeroberseite 40 aufgebracht sein können, gebildet sein.

In Figur 4A ist ein weiteres Ausführungsbeispiel des Leuchtmoduls 1 vor einer Montage an einem in Figur 4A nicht gezeichneten Kühlkörper dargestellt. Gemäß Figur 4A sind die Befestigungszungen 7 separat von der Leiterplatte 3 gefertigt und beispielsweise sowohl auf den Träger 4 als auch auf die Leiterplatte 3 aufgelötet. Eine elektrische Kontaktierung des Trägers 4 kann ebenfalls über die Befestigungszungen 7 erfolgen.

Der Träger 4 weist eine Dicke D von beispielsweise zwischen einschließlich 200 µm und 1 mm, insbesondere zwischen einschließlich 300 µm und 700 µm auf, ein mittlerer lateraler Abstand d zwischen dem Träger 4 und der Leiterplatte 3 beträgt beispielsweise circa 200 µm. Eine Überragung L, um die die Trägerunterseite 45 die Leiterplattenunterseite 45 überragt, liegt bevorzugt zwischen einschließlich 10 µm und 50 µm, wie auch in allen anderen Ausführungsbeispielen.

In Figur 4B ist das Leuchtmodul 1 auf den nicht zum Leuchtmodul 1 gehörigen Kühlkörper 8 montiert zu sehen, beispielsweise wie in einem Kfz-Scheinwerfer vorliegend.
Sowohl die Leiterplattenunterseite 35 als auch die Trägerunterseite 45 liegen planar auf einer ebenen Kühlkörperoberseite 80 des Kühlkörpers 8 auf. Mit anderen Worten ist gemäß Figur 4B die Überragung L gleich 0, da das Leuchtmodul 1 mittels der Befestigungseinrichtungen 6 auf den Kühlkörper 8 aufgedrückt ist.

Bei dem Aufdrücken auf den Kühlkörper 8 erfahren die Befestigungszungen 7 eine elastische Verformung, wodurch der Träger 4 auf die Kühlkörperoberseite 80 plan aufgedrückt ist. Es ist durch die Überragung L, siehe Figur 4A, also eine Vorspannung der Befestigungszungen 7 realisierbar, die sich bei der Montage des Leuchtmoduls 1 auf den Kühlkörper 8 in einen mechanischen Anpressdruck des Trägers 4 auf den Kühlkörper 8 übersetzt.

Die Trägerunterseite 45 ist möglichst glatt ausgeführt und weist nur eine geringe mittlere Rauheit, beispielsweise von weniger als 10 µm, auf, ebenso wie die Kühlkörperoberseite 80. Zwischen der Kühlkörperoberseite 80 und der Trägerunterseite 45 befindet sich kein Verbindungsmittel wie ein Lot oder ein Kleber. Es liegen die Kühlkörperoberseite 80 und die Trägerunterseite 45 unmittelbar aneinander an.

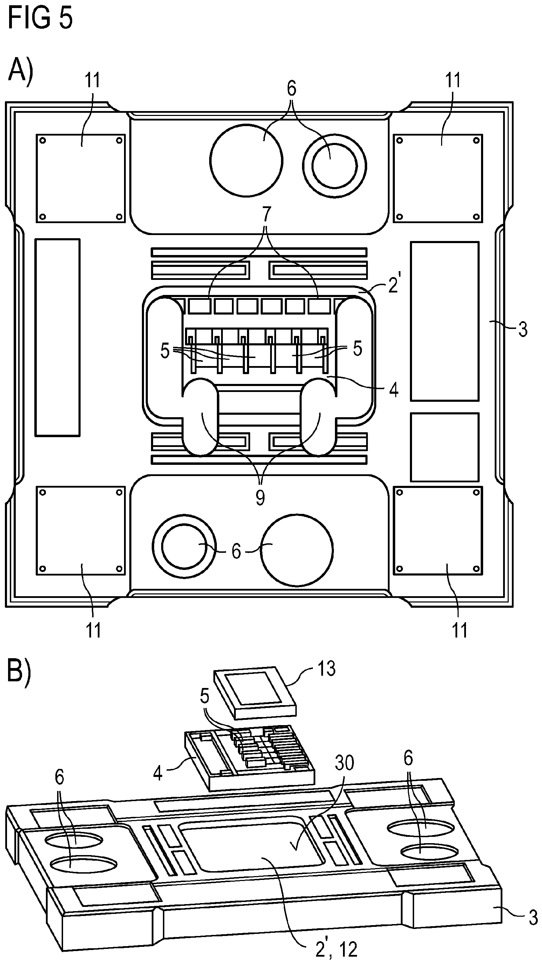

Eine Abwandlung eines Leuchtmoduls ist in der Draufsicht in Figur 5A sowie in der perspektivischen Darstellung in Figur 5B zu sehen. Der Träger 4 mit dem Halbleiterchip 5 ist in der Öffnung 2' der Leiterplatte 3 auf die Leiterplattenoberseite 30 mittels einer Verbindungsmittelschicht 12 aufgeklebt. Die Öffnung 2' durchdringt die Leiterplatte 3, die einen vergleichsweise dicken metallischen Kern umfasst, nicht vollständig, so dass eine Art Wanne gebildet wird, in der der Träger 4 angebracht ist. Eine mechanische Verbindung zwischen dem Träger 4 und der Leiterplatte 3 erfolgt im Wesentlichen nur über die Verbindungsmittelschicht 12. Da die Verbindungsmittelschicht 12 zwischen der Leiterplatte 3 und dem Träger 4 liegt, ist ein thermischer Widerstand im Vergleich zu den Ausführungsbeispielen gemäß den Figuren 1 bis 4 erhöht.

## Patentansprüche

1. Optoelektronisches Leuchtmodul (1) mit
- einer Leiterplatte (3), die von einer Öffnung (2) vollständig durchdrungen ist, wobei die Leiterplatte (3) mindestens eine Befestigungseinrichtung (6) für eine mechanische Befestigung des Leuchtmoduls (1) an einem externen Kühlkörper umfasst,
- einem Träger (4), der in der Öffnung (2) angebracht ist,
- mindestens einem optoelektronischen Halbleiterchip (5), der an einer Trägeroberseite (40) des Trägers (4) angebracht und der über den Träger (4) elektrisch mit der Leiterplatte (3) verbunden ist,
wobei
- die Leiterplatte (3) mit dem Träger (4) mechanisch fest verbunden ist,
- die Leiterplatte (3) dazu eingerichtet ist, eine mechanische Kraft auf den Träger (4) auszuüben und den Träger (4) an den externen Kühlkörper anzudrücken,
- eine Trägerunterseite (45) und eine Leiterplattenunterseite (35) planar geformt und parallel zueinander orientiert sind, und
- der Träger (4) dazu eingerichtet ist, mit der Trägerunterseite (45) plan an dem externen Kühlkörper aufzuliegen,
**dadurch gekennzeichnet, dass**
- die Trägerunterseite (45) aus der Öffnung (2) heraus die Leiterplattenunterseite (35) überragt, um eine Länge (L) von höchstens 100 µm vor einer Montage an dem externen Kühlkörper, und
- das Leuchtmodul (1) vor einer Montage an dem externen Kühlkörper als eine einzige, zusammenhängende Einheit handhabbar ist.

2. Optoelektronisches Leuchtmodul (1) nach dem vorhergehenden Anspruch,
bei dem die Leiterplatte (3) durch eines der folgenden Elemente gebildet ist:
- eine Metallkernplatine, oder
- eine Platine mit einem auf einem Epoxid basierendem Kern, auf dem eine metallische Schicht aufgebracht ist, die zu Leiterbahnen strukturiert und von einer weiteren dielektrischen Schicht zumindest stellenweise bedeckt ist.

3. Optoelektronisches Leuchtmodul (1) nach einem der vorhergehenden Ansprüche,
bei dem die Leiterplatte (3) dazu eingerichtet ist, den Träger (4) mit einer mechanischen Kraft zwischen einschließlich 5 N und 100 N und/oder mit einem mittleren Druck zwischen einschließlich 0,2 MPa und 20 MPa an den externen Kühlkörper anzudrücken.

4. Optoelektronisches Leuchtmodul (1) nach einem der vorhergehenden Ansprüche,
das mindestens zwei Befestigungszungen (7) aufweist, wobei die Befestigungszungen (7) in Verlängerung einer Leiterplattenoberseite (30) der Leiterplatte (3) verlaufen, die Öffnung (2) teilweise überdecken und mit der Trägeroberseite (40) mechanisch und elektrisch verbunden sind,
und wobei die Befestigungszungen (7) dazu eingerichtet sind, den Träger (4) an den externen Kühlkörper anzudrücken.

5. Optoelektronisches Leuchtmodul (1) nach dem vorhergehenden Anspruch,
bei dem die Befestigungszungen (7) einstückig mit der Leiterplatte (3) ausgebildet sind,
wobei die Befestigungszungen (7) an die Trägeroberseite (40) angelötet oder angeklebt sind oder eine mechanische Verbindung zwischen dem Träger (4) sowie der Leiterplatte (3) durch ein Vergussmaterial für einen Bond-Draht, der eine elektrische Brücke (9) zwischen dem Träger (4) und der Leiterplatte (3) bildet, realisiert ist.

6. Optoelektronisches Leuchtmodul (1) nach einem der Ansprüche 4 oder 5,
bei dem die Befestigungszungen (7) ein elastisch verformbares Material aufweisen oder hieraus bestehen, wobei die Befestigungszungen (7) eine Federkonstante, in eine Richtung senkrecht zu der Trägeroberseite (40), zwischen einschließlich 50 kN/m und 5 MN/m aufweisen.

7. Optoelektronisches Leuchtmodul (1) nach einem der Ansprüche 4 bis 6,
das insgesamt drei Befestigungszungen (7) aufweist, wobei mindestens eine der Befestigungszungen (7) oder alle Befestigungszungen (7) von dem Halbleiterchip (5) elektrisch isoliert sind, und
wobei durch die Befestigungszungen (7) eine Dreipunktauflage des Trägers (4) an der Leiterplatte (3) erfolgt.

8. Optoelektronisches Leuchtmodul (1) nach einem der vorhergehenden Ansprüche,
bei dem die Leiterplatte (3) in lateraler Richtung einen mittleren Abstand (d) zu dem Träger (3) zwischen einschließlich 150 µm und 750 µm aufweist.

9. Optoelektronisches Leuchtmodul (1) nach einem der vorhergehenden Ansprüche,
bei dem die Leiterplatte (3) ein spritzgegossener Schaltungsträger ist und den Träger (4) in lateraler Richtung ringsum formschlüssig umgibt.

10. Optoelektronisches Leuchtmodul (1) nach einem der vorhergehenden Ansprüche,
bei dem ein thermischer Ausdehnungskoeffizient eines Materials der Leiterplatte (3) sich von einem thermischen Ausdehnungskoeffizienten eines Materials des Trägers (4) höchstens um einen Faktor 4 unterscheidet.

11. Optoelektronisches Leuchtmodul (1) nach einem der vorhergehenden Ansprüche,
bei dem das Material des Trägers (4) bei einer Temperatur von 400 K spröder ist als ein die Leiterplatte (3) mechanisch tragendes Material.

12. Optoelektronisches Leuchtmodul (1) nach einem der vorhergehenden Ansprüche,
bei dem der Träger (4) eine Keramik oder ein Halbleitermaterial aufweist oder hieraus besteht, wobei eine Dicke (D) des Trägers (4) zwischen einschließlich 200 µm und 1 mm liegt.

13. Optoelektronisches Leuchtmodul (1) nach einem der vorhergehenden Ansprüche,
bei dem die Trägerunterseite (45) eine mittlere Rauheit von höchstens 10 µm aufweist.

14. Kfz-Scheinwerfer mit mindestens einem optoelektronischen Leuchtmodul (1) nach einem der vorhergehenden Ansprüche und mit mindestens einem Kühlkörper (8), wobei das Leuchtmodul (1) auf einer Kühlkörperoberseite (80) befestigt ist.

## Claims

1. An optoelectronic lighting module (1) having
- a printed circuit board (3), which is completely penetrated by an opening (2), wherein the printed circuit board (3) comprises at least one fastening device (6) for a mechanical fastening of the lighting module (1) on an external heat sink,
- a carrier (4), which is mounted in the opening (2),
- at least one optoelectronic semiconductor chip (5), which is mounted on a carrier top (40) of the carrier (4) and which is electrically connected to the printed circuit board (3) via the carrier (4),
wherein
- the printed circuit board (3) is rigidly mechanically connected to the carrier (4),
- the printed circuit board (3) is designed to exert a mechanical force on the carrier (4) and to press the carrier (4) against the external heat sink,
- a carrier bottom (45) and a circuit board bottom (35) are of planar shape and oriented parallel to one another and
- the carrier (4) is designed to rest with the carrier bottom (45) flat against the external heat sink, **characterized in that**
- the carrier bottom (45) projects out of the opening (2) beyond the circuit board bottom (35) by a length (L) of at most 100 µm before being mounted on the external heat sink, and
- the lighting module (1) can be handled as a single, integral unit before being mounted on the external heat sink.

2. The optoelectronic lighting module (1) according to the preceding claim,
in which the printed circuit board (3) is formed by one of the following elements:
- a metal core circuit board, or
- a circuit board with an epoxy-based core, on which a metal layer is applied which is patterned into tracks and covered by a further dielectric layer at least in some areas.

3. The optoelectronic lighting module (1) according to one of the preceding claims,
in which the printed circuit board (3) is designed to press the carrier (4) against the external heat sink with a mechanical force of between 5 N and 100 N inclusive and/or with an average pressure of between 0.2 MPa and 20 MPa inclusive.

4. The optoelectronic lighting module (1) according to one of the preceding claims,
having at least two fastening tongues (7),
wherein the fastening tongues (7) extend as extensions of a printed circuit board top (30) of the printed circuit board (3), partially cover the opening (2) and are connected mechanically and/or electrically to the carrier top (40),
and wherein the fastening tongues (7) are designed to press the carrier (4) against the external heat sink.

5. The optoelectronic lighting module (1) according to the preceding claim,
in which the fastening tongues (7) are formed in one piece with the printed circuit board (3),
wherein the fastening tongues (7) are soldered or glued to the carrier top (40) or a mechanical connection is made between the carrier (4) and the printed circuit board (3) by a casting material for a bond wire, which forms an electrical bridge (9) between the carrier (4) and the printed circuit board (3).

6. The optoelectronic lighting module (1) according to one of claims 4 or 5,
in which the fastening tongues (7) comprise or consist of an elastically deformable material, wherein the fastening tongues (7) have a spring constant in a direction perpendicular to the carrier top (40) of between 50 kN/m and 5 MN/m inclusive.

7. The optoelectronic lighting module (1) according to one of claims 4 to 6,
having a total of three fastening tongues (7), wherein at least one of the fastening tongues (7) or all of the fastening tongues (7) are electrically insulated from the semiconductor chip (5), and wherein by means of the fastening tongues (7) a three-point support of the carrier (4) on the printed circuit board (3) is obtained.

8. The optoelectronic lighting module (1) according to one of the preceding claims,
in which the printed circuit board (3) displays a mean distance (d) from the carrier (3) of between 150 µm and 750 µm inclusive in the lateral direction.

9. The optoelectronic lighting module (1) according to one of the preceding claims,
in which the printed circuit board (3) is an injection-molded circuit carrier and completely surrounds the carrier (4) in the lateral direction with a positive fit.

10. The optoelectronic lighting module (1) according to one of the preceding claims,
in which a coefficient of thermal expansion of a material of the printed circuit board (3) differs from a coefficient of thermal expansion of a material of the carrier (4) by at most a factor of 4.

11. The optoelectronic lighting module (1) according to one of the preceding claims,
in which the material of the carrier (4) is more brittle at a temperature of 400 K than a material mechanically supporting the printed circuit board (3).

12. The optoelectronic lighting module (1) according to one of the preceding claims,
in which the carrier (4) comprises a ceramic or a semiconductor material or consists thereof, wherein a thickness (D) of the carrier lies between 200 µm and 1 mm inclusive.

13. The optoelectronic lighting module (1) according to one of the preceding claims,
in which the carrier bottom (45) has an average roughness of at most 10 µm.

14. An automotive headlamp having at least one optoelectronic lighting module (1) according to one of the preceding claims and having at least one heat sink (8), wherein the lighting module (1) is fastened to a heat sink top (80).

## Revendications

1. Module lumineux (1) optoélectronique comprenant
- une plaquette à circuit imprimé (3) qui est complètement traversée par une ouverture (2), la plaquette à circuit imprimé (3) comprenant au moins un dispositif de fixation (6) pour une fixation mécanique du module lumineux (1) sur un corps de refroidissement externe,
- un support (4) qui est placé dans l'ouverture (2),
- au moins une puce à semi-conducteur (5) optoélectronique qui est placée sur un côté supérieur (40) du support (4) et qui est reliée électriquement à la plaquette à circuit imprimé (3) par l'intermédiaire du support (4),
- la plaquette à circuit imprimé (3) étant mécaniquement reliée au support (4) de manière fixe,
- la plaquette à circuit imprimé (3) étant configurée pour exercer une force mécanique sur le support (4) et pour presser le support (4) sur le corps de refroidissement externe,
- un côté inférieur de support (45) et un côté inférieur de plaquette à circuit imprimé (35) étant formés de manière plane et orientés parallèlement l'un à l'autre, et
- le support (4) étant conçu pour reposer sur le corps de refroidissement externe avec le côté inférieur de support (45),
**caractérisé en ce que**
- le côté inférieur de support (45) fait saillie du côté inférieur de plaquette à circuit imprimé (35) en sortant de l'ouverture (2), d'une longueur (L) de maximum 100 µm avant un montage sur le corps de refroidissement externe, et
- **en ce que** le module lumineux (1) est maniable comme unité homogène avant un montage sur le corps de refroidissement externe.

2. Module lumineux (1) optoélectronique selon la revendication précédente,
dans lequel la plaquette à circuit imprimé (3) est formée par l'un des éléments suivants :
- un substrat métallique ou
- une platine munie d'un noyau basé sur un époxyde, sur lequel est appliquée une couche métallique qui est structurée en pistes conductrices et est recouverte au moins par endroits par une couche diélectrique supplémentaire.

3. Module lumineux (1) optoélectronique selon l'une quelconque des revendications précédentes,
dans lequel la plaquette à circuit imprimé (3) est configurée pour presser le support (4) sur le corps de refroidissement externe avec une force mécanique comprise entre, y compris, 5 N et 100 N et/ou avec une pression moyenne comprise entre, y compris, 0,2 MPa et 20 MPa.

4. Module lumineux (1) optoélectronique selon l'une quelconque des revendications précédentes,
lequel présente au moins deux languettes de fixation (7), les languettes de fixation (7) s'étendant en prolongement d'un côté supérieur (30) de la plaquette à circuit imprimé (3), recouvrant en partie l'ouverture (2) et étant reliées mécaniquement et électriquement au côté supérieur de support (40),
et les languettes de fixation (7) étant conçues pour presser le support (4) sur le corps de refroidissement externe.

5. Module lumineux (1) optoélectronique selon la revendication précédente,
dans lequel les languettes de fixation (7) sont réalisées d'une seule pièce avec la plaquette à circuit imprimé (3),
les languettes de fixation (7) étant soudées ou collées sur le côté supérieur de support (40), ou une liaison mécanique entre le support (4) et la plaquette à circuit imprimé (3) étant réalisée au moyen d'une matière d'enrobage pour un fil de connexion qui forme un pont électrique (9) entre le support (4) et la plaquette à circuit imprimé (3).

6. Module lumineux (1) optoélectronique selon l'une quelconque des revendications 4 ou 5,
dans lequel les languettes de fixation (7) présentent une matière élastiquement déformable ou en sont constituées, les languettes de fixation (7) présentant une constante de ressort, dans une direction perpendiculaire au côté supérieur de support (40), comprise entre, y compris, 50 kN/m et 5 MN/m.

7. Module lumineux (1) optoélectronique selon l'une quelconque des revendications 4 à 6,
lequel présente en tout trois les languettes de fixation (7), au moins une des languettes de fixation (7) ou toutes les languettes de fixation (9) étant électriquement isolées de la puce à semi-conducteur (5), et
un appui à trois points du support (4) étant réalisé sur la plaquette à circuit imprimé (3) par les languettes de fixation (7).

8. Module lumineux (1) optoélectronique selon l'une quelconque des revendications précédentes,
dans lequel la plaquette à circuit imprimé (3) présente en direction latérale un écart moyen (d) par rapport au support (3) compris entre, y compris, 150 µm et 750 µm.

9. Module lumineux (1) optoélectronique selon l'une quelconque des revendications précédentes,
dans lequel la plaquette à circuit imprimé (3) est un support de circuit moulé par injection et entoure le support (4) en direction latérale sur tous les côtés par adhérence de forme.

10. Module lumineux (1) optoélectronique selon l'une quelconque des revendications précédentes,
dans lequel un coefficient de dilatation thermique d'une matière de la plaquette à circuit imprimé (3) se distingue d'un coefficient de dilatation thermique d'une matière du support (4) au maximum d'un facteur 4.

11. Module lumineux (1) optoélectronique selon l'une quelconque des revendications précédentes,
dans lequel la matière du support (4), à une température de 400 K, est plus friable qu'une matière portant la plaquette à circuit imprimé (3) mécaniquement.

12. Module lumineux (1) optoélectronique selon l'une quelconque des revendications précédentes,
dans lequel le support (4) présente une céramique ou une matière semi-conductrice ou en est constitué, une épaisseur (D) du support (4) étant située entre, y compris, 200 µm et 1 mm.

13. Module lumineux (1) optoélectronique selon l'une quelconque des revendications précédentes,
dans lequel le côté inférieur de support (45) présente une rugosité moyenne de maximum 10 µm.

14. Projecteur pour véhicule automobile comprenant au moins un module lumineux (1) optoélectronique selon l'une quelconque des revendications précédentes et comprenant au moins un corps de refroidissement (8), le module lumineux (1) étant fixé sur un côté supérieur (80) du corps de refroidissement.
